# EUROPÄISCHE PATENTSCHRIFT

(11) **EP 1 053 214 B1**
(45) Veröffentlichungstag und Bekanntmachung des Hinweises auf die Patenterteilung: **05.03.2008**
(21) Anmeldenummer: 99967873.3
(22) Anmeldetag: 09.12.1999
(51) Int. Cl.: C04B 35/634, C04B 35/486, C08K 3/22

(54) **POLYMERCOMPOUND, DESSEN HERSTELLUNG UND VERWENDUNG SOWIE DARAUS HERGESTELLTER SINTERKÖRPER**
POLYMER COMPOUND, THE PRODUCTION AND USE THEREOF, AND SINTERED COMPACTS PRODUCED THEREFROM
MELANGE POLYMERE, SA PRODUCTION ET SON UTILISATION, ET CORPS FRITTE PRODUIT A PARTIR DE CE MELANGE

(30) Priorität: 10.12.1998 DE 19857063; 02.12.1999 DE 19958197
(43) Veröffentlichungstag der Anmeldung: 22.11.2000
(73) Patentinhaber: ROBERT BOSCH GMBH, 70442 Stuttgart (DE)
(72) Erfinder: SCHEYING, Gerd, D-70186 Stuttgart (DE); KANTERS, Johannes, D-47918 Tönisvorst (DE); WUEHRL, Ingrid, D-70839 Gerlingen (DE); EISELE, Ulrich, D-70199 Stuttgart (DE); BOEDER, Horst, D-71069 Sindelfingen (DE); DORFMUELLER, Lutz, D-70499 Stuttgart (DE); GRUENWALD, Werner, D-70839 Gerlingen (DE)
(86) Internationale Anmeldenummer: PCT/DE1999/003934
(87) Internationale Veröffentlichungsnummer: WO 2000/034204

(56) Entgegenhaltungen:
- EP-A- 0 313 412
- EP-A- 0 561 343
- WO-A-92/07026
- DATABASE WPI Week 198434 Derwent Publications Ltd., London, GB; AN 1984-209691 XP002137847 & JP 59 121151 A (NISSAN MOTOR CO., LTD.), 13. Juli 1984 (1984-07-13)

## Beschreibung

Die Erfindung betrifft ein Polymercompound, ein Verfahren zu seiner Herstellung, seine Verwendung und ein daraus hergestellter Sinterkörper.

### Stand der Technik

Der Spritzguß (CIM = ceramic injection moulding) oder die Extrusion stellen zwei wichtige Verfahren bei der keramischen Formgebung dar. Hierbei ist zunächst die Herstellung eines sogenannten Polymercompounds erforderlich. Hierunter versteht man die Dispersion von Keramikteilchen in einer hochviskosen polymeren Matrix. Durch Verarbeitung einer solchen Mischung im Spritzguß oder der Extrusion wird die gewünschte Form erzielt. Nach Entfernung der organischen Hilfsstoffe (Entbindern) liegt ein keramischer Grünkörper vor, der durch Sintern verdichtet wird. Damit diese Sinterung zu einem dichten Körper führt, muß der keramische Feststoffgehalt des Grünkörpers ausreichend hoch sein, wobei er mehr als 40 Vol.-% betragen soll, d.h. in diesem Fall soll auch der Polymercompound mindestens zu 40% gefüllt sein.

Nanoskalige Pulver liegen immer agglomeriert vor. Die Stärke der Agglomerate, die sogenannte Agglomerathärte, hängt von der Vorgeschichte der Pulver ab. Die Palette reicht von Van-der-Waals-Austauschkräften über Wasserstoffbrückenbindungen bis hin zu echten Sinterhälsen. Um die Agglomerationsneigung abzuschwächen, werden die Oberflächen von Pulvern mit Synthesehilfsstoffen geschützt. Hierbei ist jedoch als nachteilig anzusehen, daß bei der Pulverherstellung keine hohen Temperaturen zum Einsatz kommen können, so daß die Pulver oftmals noch amorphe Anteile enthalten. Ferner wird als nachteilig angesehen, daß die Hilfsstoffe bei der weiteren Verarbeitung stören.

Bei der Herstellung von keramischen Grünkörpern durch Extrusion oder CIM und bei der Erzeugung von hochgefüllten Kunststoffen werden heute üblicherweise Pulver eingesetzt, deren spezifische Oberfläche den Wert von 15 m²/g in der Regel nicht übersteigt. Es werden also Pulver mit einer relativ geringen spezifischen Oberfläche eingesetzt. Der Grund hierfür liegt darin, daß die Agglomerationsneigung feinerer Pulver vergleichsweise viel höher ist, sowie deren Agglomerathärte und dem damit verbundenen Energieaufwand bei der Zerkleinerung dieser Pulveragglomerate, sofern dies überhaupt möglich ist.

Es gibt jedoch Einsatzzwecke, bei denen eine große Oberfläche der Füllstoffe wünschenswert ist. Mit steigendem Oberflächen-Volumenverhältnis nehmen die Wechselwirkungen der Füllstoffe mit der umgebenden Matrix zu.

Über diese Wechselwirkungen definieren sich die gewünschten Eigenschaften partikelgefüllter Kunststoffe.

Pulver aus Zirkoniumdioxid lassen sich auf pulvermetallurgischem Weg durch Sintern zu Körpern mit weniger als 5% Porosität verarbeiten. Dieses Material besteht aus tetragonalen Körnern, aus einer Mischung von tetragonalen, monoklinen und kubischen Körnern oder rein aus monoklinen Körnern. Die tetragonale Phase wird durch eine kleine Korngröße, durch Dotierung mit Fremdelementen, durch hohe Temperatur, durch intrinsischen Druck des Gefüges und durch äußeren Druck stabilisiert. Im Folgenden wird die kleine Korngröße als Teilchengrößenstabilisierung und der intrinsische Druck des Gefüges als Gefügestabilisierung bezeichnet. Das Zirkoniumdioxid mit gemischten Phasenanteilen zeigt intrinsische Spannungen des Gefüges, die den tetragonalen Anteil stabilisieren.

Diese intrinsischen Spannungen führen zu sehr hohen Festigkeiten des Materials. Dabei läßt sich jedoch bisher Zirkoniumdioxid mit gemischten Phasenanteilen nur unter Zuhilfenahme von mehr als 1 Mol-% Dotierstoffen herstellen, was als nachteilig angesehen wird. Bekannte Dotierstoffe sind hierbei zum Beispiel Y₂O₃, CaO, CeO₂ oder MgO.

Weiterhin ist aus der EP 0561343 A, aus der EP 0313412 A und aus der JP 59121151 A die Herstellung von Precursor-Materialien bekannt, die keramische und/oder metallische Pulver enthalten und zusätzlich einen Binder. Darüber hinaus ist aus der WO 92/07026 A eine thermoplastische Schmelzmasse bekannt, die neben einem polymeren Binder zusätzlich keramische Füllstoffe enthält.

### Aufgabe und Vorteile der Erfindung

Die Aufgabe vorliegender Erfindung bestand darin, ein Polymercompound und ein Verfahren zu seiner Herstellung bereitzustellen, bei dem eine Dispersion von freien nanokristallinen Keramikpartikeln vorliegt.

Diese Aufgabe wird in überraschender Weise durch ein Polymercompound umfassend ein keramisches Pulver und ein Polymer, gelöst, wobei das Pulver eine spezifische Oberfläche von mehr als 1,8·10⁸ m²/m³ aufweist und mehr als 5 Vol.-% des Polymercompounds beträgt, das Polymer scherkraftbeständig ist und die Porengrößen im Polymercompound 3-15 nm betragen.

Ferner bestand die Aufgabe darin, unter Verwendung eines Polymercompounds zu einem Sinterkörper aus Zirkoniumdioxid mit einer sehr hohen Festigkeit zu gelangen, ohne den Einsatz von mehr als 0,8 Mol.% Dotierstoffen.

Diese Aufgabe wird dadurch gelöst, dass das keramische Pulver in dem erfindungsgemäßen Polymercompound mehr als 40 Vol.-% beträgt.

In besonders vorteilhafter Weise läßt sich nunmehr ein aus diesen erfindungsgemäßen Polymercompound hergestellter Grünkörper bei einer um 200-300 K niedrigeren Temperatur sintern, als mit den im Stand der Technik eingesetzten Pulvern.

Bevorzugt ist ein Polymercompound, bei dem das keramische Pulver mehr als 40 und weniger als 50 Vol.-% beträgt.

Bevorzugt ist ferner ein Polymercompound, der zusätzlich eine oder mehrere gesättigte oder ungesättigte C₂-C₁₈-Carbonsäuren und/oder ein oder mehrere gesättigte oder ungesättigte C₂-C₁₈-alkyl-dimethylsubstituierte Chlorsilane und/oder ein oder mehrere gesättigte oder ungesättigte C₂-C₁₈-Alkylamine aufweist.

Bevorzugt ist ein Polymercompound, bei dem das keramische Pulver eine spezifische Oberfläche von mehr als 2,5·10⁸ m²/m³ aufweist.

Des weiteren ist insbesondere ein Polymercompound bevorzugt, bei dem das Polymer ein Polyolefin, ein Polyester oder ein Polyamid als Thermoplast umfaßt.

Als Polyolefine sind HD-Polyethylen, LD-Polyethylen, Copolymere aus Polyethylen mit Vinylacetat oder Butylacrylat, Polypropylen sowie ein mit Acrylsäure oder Maleinsäureanhydrid gepfropftes Polypropylen bevorzugt.

Das mit Vinylacetat copolymerisierte Polyethylen weist einen Vinylacetatanteil von bis zu 50% auf, das mit Butylacrylat polymerisierte Polyethylen einen Butylacrylatanteil von bis zu 30%. Das mit Maleinsäureanhydrid gepfropfte Polyethylen weist 3% Maleinsäureanhydrid auf, das mit Acrylsäure gepfropfte Polypropylen weist 6% Acrylsäure auf.

Als Polyester sind Polyethylenterephthalat, Polybutylenterephthalat, Polycarbonat oder Polylacton bevorzugt. Als Polyamide sind Polyamid 6, Polyamid 12 und Polyamid 66 bevorzugt.

Als bevorzugte keramische Pulver werden Oxide, wie z.B. ZrO₂, Al₂O₃, SiO₂, MgO, TiO₂, Y₂O₃, Carbide, Nitride oder deren Mischungen, eingesetzt. Als keramische Pulver für den Polymercompound sind alle Arten von Zirconiumdioxiden, auch mit Anteilen anderer Metalloxide, geeignet. Ferner eigenen sich die alpha-, gamma- und delta-Aluminiumoxide sowie alle einfachen und zusammengesetzten Oxide basischer oder amphoterer Oberfläche. Besonders bevorzugt ist amorphes SiO₂ (Aerosil^{®}). Bei Verwendung von Siliciumdioxid ist der Einsatz eines Silandispergators besonders bevorzugt. Bei den Carbiden sind insbesondere Silicium- und Wolframcarbid geeignet. Als Nitride sind insbesondere Si₃N₄ und A1N geeignet, wobei vorzugsweise ein Amin als Dispergator zum Einsatz kommt.

Bei dem neuen Verfahren ist vor allem die einfache und sehr schnelle Einarbeitung (Compoundierung) des Pulvers in die Mischung in nur einem Aggregat, dem Kneter, besonders vorteilhaft. Ein weiterer Vorteil liegt in der Möglichkeit, ein heterogenes Werkstoffsystem zu erzeugen, dessen Eigenschaften nur noch von den Wechselwirkungen an den Phasengrenzflächen der Inhaltsstoffe bestimmt wird.

Thermoplaste mit einer starken Neigung zum thermomechanischen Abbau unter überwiegender oder vollständiger Zersetzung sind zum Einsatz beim erfindungsgemäßen Verfahren nicht geeignet.

Der Gegenstand der Erfindung ist ferner ein Verfahren zur Herstellung des Polymercompounds unter Verwendung eines keramischen Pulvers und eines Thermoplasten, wobei das keramische Pulver eines mit einer spezifischen Oberfläche von mehr als 1,8·10⁸ m²/m³ als Thermoplast, ein scherkraftbeständiges Polymer in einem Kneter mit einer derart hohen Scherkraft geknetet werden, daß die Porengrößen im Polymercompound bei einer Füllung des Polymers mit dem keramischen Pulver von mindestens 5 Vol.-% 3-15 nm betragen.

Durch das erfindungsgemäße Verfahren können nunmehr in überraschender Weise auch agglomerierte Pulver bis auf ihre Primärteilchengröße aufgeschlossen werden, wodurch Polymercompounds und daraus hergestellte Körper mit den oben genannten Porengrößen herstellbar werden.

Das neuartige Verfahren besteht darin, daß eine Mischung aus einem agglomerierten keramischen Pulver, wobei die Primärteilchengröße ≤ 30 nm und agglomeriert 1 µm und darüber beträgt, einem Dispergator, wie Carbonsäure und einem Thermoplasten, der hohe Scherkräfte verträgt, in einem Kneter mit derart hohen Scherkräften aufbereitet wird, daß das Pulver deagglomeriert wird und dessen Primärteilchen hierdurch vereinzelt und durch den Dispergator geschützt vorliegen. Durch den Dispergator werden die Primärteilchen vor einer Reagglomeration geschützt.

Durch das erfindungsgemäße Verfahren werden im Polymercompound Feststoffgehalte von bis zu 57 Vol.-% erreicht. Ferner werden durch das Verfahren Porengrößen bis hinunter zu 3 nm mit enger Verteilung erzielt. Diese beiden Befunde zeigen eindeutig, daß die Agglomerate aufgebrochen wurden. Agglomerierte Pulver sind normalerweise für die keramische Prozeßtechnik untauglich und durch Mahlprozesse aller Art nicht in diesem Maße deagglomerierbar.

Durch den im erfindungsgemäßen Verfahren angewandten Scherprozeß bleibt die spezifische Oberfläche des Pulvers gleich oder sie vergrößert sich. Dies konnte durch Stickstoffadsorption bei 77 K nach der BET-Methode nachgewiesen werden.

Die Porengrößen im Grünkörper wurden mittels N₂-Desorption oder Hg-Porosimetrie gemessen. Dabei ergab sich, daß die mittlere Porengrößen mindestens um den Faktor zwei kleiner sind, als die auf die gleiche Weise am Pulver gemessenen mittleren Porengrößen. Ferner ergab sich, daß diese eine enge monomodale Verteilung des Porenvolumens über dem Porendurchmesser aufweisen.

Die Zugabe der gesättigten oder ungesättigten Carbonsäure(n) während der Compoundierung als Dispergator führt dazu, daß eine chemische Reaktion der Carboxylgruppe mit der Pulveroberfläche stattfindet. Hierbei wird die Carboxylgruppe in die resonanzstabilisierte, negativ geladene, Carboxylatgruppe umgewandelt, und diese lagert sich an positive Ladungszentren auf der Pulveroberfläche an, so daß es zu einer adsorptiven ionischen Bindung kommt. Dies konnte durch Fourier-Transformations-IR-Spektren für die Decansäure als Dispergator und Zirconiumdioxid nachgewiesen werden.

Bei Verwendung der gesättigten oder ungesättigten alkyldimethylsubstituierten Chlorsilanen als Dispergator kommt es zu einer Reaktion zwischen der Pulveroberfläche und den Chlorsilanen. Als besonders vorteilhaft hat sich die Anwendung von Dimethyl-alkyl-chlorsilan als Dispergator für nanoskalige carbidische Pulver erwiesen, wobei der Alkylrest den C₁ - C₁₈ - Rest umfaßt.

Die Porengrößen in dem Polymercompound liegen bei entsprechender Füllung des Organikanteils zwischen 3 und 15 nm. Dadurch ist die Beweglichkeit der Makromoleküle bis zu einer untersuchten Temperatur von 300°C stark eingeschränkt. Das führt in besonders vorteilhafter Weise zu einem thermomechanischen Verhalten, bei dem das Speichermodul des erfindungsgemäßen Polymercompounds bis zu einer Temperatur von 300°C praktisch konstant bleibt.

Das Polymercompound, das nach dem erfindungsgemäßen Verfahren hergestellt wurde, kann als Ausgangsstoff für die keramische Formgebung durch Spritzguß, Extrusion, Warm- und Kaltpressen, Kalandrieren oder Walzen dienen. Hierbei können dichte keramische Grünkörper und nach Entbinderung und Sinterung dichte keramische Körper und solche mit definierter offener und/oder geschlossener Porosität hergestellt werden.

Die erfindungsgemäßen Polymercompounds können als Formkörper in Form eines Stranges oder Hohlstranges beliebigen Querschnitts, eines Rohres, eines Vierkants oder einer Folie vorliegen. So wurden beispielsweise Stränge mit 6-8 mm Durchmesser, Rohre mit 14 mm x 3 mm, Vierkante mit 4 mm x 5 mm, Folien mit 10 mm x 1 mm und insbesondere Folien mit 75 mm x 0,5 mm hergestellt.

Die Polymercompounds können als Formkörper mittels des Spritzgußverfahrens auch als komplexe dreidimensionale Körper vorliegen.

Die erfindungsgemäßen Polymercompounds eignen sich auch als partikelverstärkter Kunststoff.

Darüber hinaus sind die erfindungsgemäßen Polyme r-compounds geeignet als Masterbatch zur Erzeugung gefüllter Kunststoffe. Als Füllstoffe werden insbesondere funktionelle Füllstoffe, z.B. für die Farbgebung, mit dielektrischen Eigenschaften (Isolierstoffe), elektrische Leitfähigkeit und/oder UV-Absorption eingesetzt.

Bei den erfindungsgemäß hergestellten Folien zeigte sich ein besonderer Vorteil in deren Flexibilität, welche für die Bedruckbarkeit notwendig ist. Hierbei kommt die übliche Dickschichttechnik zum Einsatz. Beim Bedrucken zeigte sich, daß eine gute Verträglichkeit zu organischen Systemen der Druckpasten, insbesondere zu Polyvinylbutyral und hochsiedenden Lösemitteln auf Ether- und Esterbasis besteht.

Die erfindungsgemäßen Polymercompounds eignen sich auch zur Verwendung als Leiterplattenmaterial.

Die bisher verwendeten Leiterplattenmaterialien sind beispielsweise aramidfaserverstärkter Kunststoff oder glasfaserverstärkte Epoxidharze. Diese Materialien können jedoch nicht voll befriedigen.

Erwünscht ist ein Leiterplattenmaterial mit angepasstem thermischen Ausdehnungskoeffizienten zur Minimierung thermischer Spannungen in integrierten Bauelementen und deren elektrische Kontaktierungen. Ferner ist ein Dielektrikum für auf FR4-Leiterplattenträgern nachträglich aufgebrachten Verbindungs- und dielektrischen Ebenen erwünscht, wie beispielsweise sogenannte RCC-Folien (resin coated copper foils), die Ausdehnungskoeffizienten zwischen Kernmaterial und Bauelementen ausgleichen. Ferner ist ein Dielektrikum für die Montage von Halbleiterbauelementen auf metallischen Wärmesenken mit verbesserter Wärmeleitfähigkeit und angepasstem thermischen Ausdehnungskoeffizienten erwünscht.

Die aus den erfindungsgemäßen Polymercompounds hergestellten Leiterplatten erreichen diese Ziele durch eine gegenüber den bekannten Leiterplatten verbesserte Wärmeleitfähigkeit, Reduzierung der thermischen Spannungen infolge eines geringeren Wärmeausdehnungskoeffizienten und bei Verwendung von nanokristallinem amorphen SiO₂ auch als besonders gut zugängliche und kostengünstige Ausführungsform. Hierbei kann ein Wärmeausdehnungskoeffizient von 0,5 ppm/K und eine Wärmeleitfähigkeit von 1,3 W/mK erreicht werden.

Durch die Verstärkung mit nanokristallinen Partikeln kann die Dauergebrauchstemperatur von einfachen Thermoplasten auf ca. 200° gesteigert werden. Bereits bei Füllgehalten des Polymers von mehr als 5 Vol.-% werden die Wärmeausdehnungskoeffizienten von herkömmlichen Leiterplattenmaterialien unterschritten und es wird eine gute Anpassung an den Wärmeausdehnungskoeffizient von Chips erreicht. Das Optimum für diese Anwendung der Polymercompounds liegt bei einem Füllgehalt von 40 - 50 Vol.-%.

Der Wärmeausdehnungskoeffizient der Mischung ist gegenüber dem reinen Polymer mit 5 - 8 ppm/K stark reduziert. Die durch thermisches Zyklieren auftretenden Spannungen in montierten Bauelementen und deren Kontaktierungen werden dadurch minimiert.

Des weiteren wird die Wärmeleitung gegenüber dem reinem Polymer und gegenüber den Leiterplattenmaterialien des Standes der Technik erhöht.

Durch den Einsatz von Aerosil^{®} wird die Dauergebrauchstemperatur gegenüber dem reinen Polymer auf über 200°C angehoben. Damit wird das Substrat beispielsweise auch gegenüber bleifreien Loten mit höherer Schmelztemperatur beständig.

Die erfindungsgemäßen Polymercompounds eignen sich auch als Vergussmasse für elektrische oder elektronische Komponenten.

Ein weiterer Vorteil des erfindungsgemäßen Verfahrens und der Verwendung der damit hergestellten Produkte besteht darin, daß sämtliche verwendete Inhaltsstoffe nicht umweltgefährdend und aufgrund der sehr hohen oder nicht vorhandenen MAK-Schwellen problemlos in einem industriellen Prozeß einsetzbar sind.

### Beispiele zur Herstellung des Polymercompounds

### Beispiel 1

Es wurde eine Mischung aus 86,6 Massen% VP-ZrO₂ mit einer spezifischen Oberfläche von 54 m²/g (=3,1·10⁸ m²/m³) (Hersteller: Degussa AG), 4 Massen% Decansäure und 9,4 Massen% Polyethylen-vinylacetat mit einem Vinylacetatanteil von 28% hergestellt. Diese Mischung wurde drei Stunden im Zwangs-Innenmischer W 350 der Firma Brabender geknetet. Hierbei trat ein maximales Drehmoment von 350 Nm auf.

Die mittlere Porengröße im entbinderten Polymercompound betrug 8 nm. Im Polymercompound lag das Pulver mit einem Anteil von 50 Vol.-% vor.

### Beispiel 2

Es wurde eine Mischung aus 83,2 Massen% ZrO₂ mit einer spezifischen Oberfläche von 132 m²/g (=7,7·10⁸ m²/m³) (Hersteller: Institut für Neue Materialien, Saarbrücken), 9,5 Massen% Decansäure und 7,3 Massen% Polyethylen-vinylacetat mit einem Vinylacetatanteil von 28% hergestellt. Diese Mischung wurde 90 Minuten im Zwangs-Innenmischer W 350 der Firma Brabender geknetet. Hierbei trat ein maximales Drehmoment von 440 Nm auf.

Die mittlere Porengröße im entbinderten Polymercompound betrug 3,5 nm. Im Polymercompound lag das Pulver mit einem Anteil von 43,6 Vol.-% vor.

### Beispiel 3

Es wurde eine Mischung aus 87,5 Massen% eines für die Katalyse hergestellten ZrO₂ mit einer spezifischen Oberfläche von 35 m²/g (=2,0·10⁸ m²/m³), 2, 9 Massen% Decansäure und 9,6 Massen% Polyethylen-vinylacetat mit einem Vinylacetatanteil von 28% hergestellt. Diese Mischung wurde 90 Minuten im Zwangs-Innenmischer W 350 der Firma Brabender geknetet. Hierbei trat ein maximales Drehmoment von 340 Nm auf.

Die mittlere Porengröße im entbinderten Polymercompound betrug 12 nm. Im Polymercompound lag das Pulver mit einem Anteil von 52 Vol.-% vor.

### Beispiel 4

Es wurde eine Mischung 83,1 Massen% TiO₂ P25 mit einer spezifischen Oberfläche von 50 m²/g (=1,9·10⁸ m²/m³) (Hersteller: Degussa AG), 4,4 Massen% Decansäure und 12,5 Massen% HD-Polyethylen mit einer Mol-Massen von 300.000 g/mol (Gewichtsmittel aus Gelpermeationschromatographie) hergestellt. Diese Mischung wurde 80 Minuten im Zwangs-Innenmischer W 50 der Firma Brabender geknetet. Hierbei trat ein maximales Drehmoment von 70 Nm auf.

Die mittlere Porengröße im entbinderten Polymercompound betrug 11 nm. Im Polymercompound lag das Pulver mit einem Anteil von 50 Vol.-% vor.

### Beispiele zur Herstellung der Formkörper

### Beispiel 5

Es wurde der gemäß Beispiel 1 hergestellte Polymercompound nach vorangegangener Granulierung in einer Schlagwerksmühle oder einem Backenbrecher in einem Brabender-Extruder mit einer Foliendüse geformt. Der Extruder besaß eine Thermoplast-Förderschnecke mit einem Längen-Durchmesser-Verhältnis von 25 bei einem Schneckendurchmesser von 19 nm. Die Düse als Formungswerkzeug hatte die Dimensionen 75 x 0,55 mm. Die Zylinder- und Düsentemperatur betrug 230° C.

Bei einer Extrusionsgeschwindigkeit von 0,1 bis 0,2 m/s betrug der in der Austragszone gemessene Druck 7·10⁷ Pa und das am Antrieb gemessene Drehmoment 100 Nm.

### Beispiel 6

Es wurde der gemäß Beispiel 3 hergestellte Polymercompound nach vorangegangener Granulierung in einer Schlagwerksmühle oder einem Backenbrecher mit einer 100-Spritzgußmaschine der Fa. Arburg mit einem Werkzeug bestehend aus zwei Formnestern der Vierkantgeometrie 4 x 5 x 80 mm³ geformt. Dabei betrug die Zylindertemperatur 220°C, die Werkzeugtemperatur 80°C, die Einspritzzeit 0,6s, die Nachdruckzeit 20s, ebenso die Kühlzeit. Der Nachdruck betrug 1,2 ·10⁸ Pa.

Ein weiterer Gegenstand der Erfindung ist ein Verfahren zur Herstellung eines keramischen Sinterkörpers, wobei der Polymercompound nach seiner Formgebung entbindert und gesintert wird.

Die so hergestellten Formkörper, beispielsweise aus Zirkoniumdioxid können bei 1.100°C vollständig verdichtet werden. Aufgrund dieser besonders niedrigen Sintertemperatur im Vergleich zur Standard-Pulversintertemperatur von 1.400°C ist nunmehr durch Cosintern möglich, neue Verbundstoffe wie zum Beispiel Sensorelemente oder elektrische Bauteile herzustellen.

### Beispiel für die Herstellung eines Keramikkörpers aus dem Polymercompound

### Beispiel 7

Der gemäß Beispiel 1 hergestellte und gemäß Beispiel 5 geformte Polymercompound ergab nach dem Entbindern der organischen Bestandteile einen ungesinterten keramischen Körper (Grünkörper). Durch zehnstündiges Sintern bei 1.100°C an Luft trat eine technische Schwindung von linear 16,4% auf. Dabei entstand ein Körper mit einer Porosität von 5% und einem rein monoklinem Phasenanteil des ZrO₂.

Ein weiterer Gegenstand der Erfindung ist ein Sinterkörper, herstellbar aus einem erfindungsgemäßen Polymercompound, aus ZrO₂ mit einem tetragonalen Phasenanteil und mit einer Porosität von weniger als 5 %, der dadurch gekennzeichnet ist, daß er weniger als 0,8 Mol-% Fremdelemente, ausgenommen Hafnium, und einen monoklinen Phasenanteil von weniger als 90% aufweist.

Durch diese erfindungsgemäße Lösung, also durch die kombinierte Teilchen- und Gefügestabilisierung, konnte eine hohe Bruchfestigkeit des Sinterkörpers erzielt werden, wobei eine wesentliche Reduzierung des Anteils an Dotierstoffen erreicht werden konnte. Erst durch den Einsatz der erfindungsgemäßen Polymercompounds mit der Stabilisierung der nanokristallinen Rohstoffe konnte der neue Sinterkörper realisiert werden.

Der erfindungsgemäße Sinterkörper aus ZrO₂ wird bei einem Fremdelementanteil von weniger als 0,8 Mol-% als undotiert bezeichnet. Die durchschnittliche Korngröße in dem gesinterten Gefüge beträgt weniger als 100 nm. Unterschiedliche monokline Anteile des Materials wie auch unterschiedliche tetragonale Anteile können durch Variation der Sinterbedingungen eingestellt werden. Während des Sinterns wachsen die Körner an. Der Anteil der Körner, die nach dem. Abkühlen des Körpers eine kritische Korngröße überschritten haben und monoklin vorliegen, steigt mit zunehmender mittlerer Korngröße. Deshalb wächst mit zunehmender Sinterdauer und -temperatur auch der monokline Phasenanteil.

Die in dem Sinterkörper enthaltenen etwa 2 Mol-% HfO₂ sind natürlicher Gehalt. HfO₂ wirkt nicht als Dotierung zur Stabilisierung der tetragonalen Phase.

Zur Herstellung des undotierten, gefügestabilisierten Zirkoniumdioxids werden sehr feine Ausgangspulver mit mittleren Korngrößen von weniger als 12 nm eingesetzt. Es ist bei seiner Herstellung darauf zu achten, daß die mittlere Korngröße während der Sinterung nicht auf Werte von über 100 nm anwächst, was durch die Verarbeitung der Ausgangspulver in den beschriebenen erfindungsgemäßen Verfahren gewährleistet ist.

Ausgangspulver in den beschriebenen erfindungsgemäßen Verfahren gewährleistet ist.

### Beispiele zur Herstellung eines undotierten, gefügestabilisierten Zirkoniumdioxids

### Beispiel 8

Es wurde ein Polymercompound gemäß Beispiel 2 hergestellt und entsprechend Beispiel 5 geformt. Nach dem Entbindern der organischen Bestandteile lag der ungesinterte keramische Körper als Grünkörper vor. Durch vierstündiges Sintern an Luft bei 970°C entstand daraus ein Körper mit einer Porosität von 3 % und einem monoklinen Phasenanteil von 30,5 %. Der restliche Teil des Gefüges war tetragonal und kubisch. Der Anteil an ZrO₂ und HfO₂ betrug mehr als 99,2 Mol-%. Die mittlere Korngröße des gesinterten Körpers betrug 62 nm.

### Beispiel 9

Es wurde ein Polymercompound gemäß Beispiel 2 hergestellt. Nach dem Entbindern der organischen Bestandteile und 15-stündigem Sintern an Luft bei 1020°C wurde ein keramischer Körper erhalten. Seine mittlere Korngröße betrug 73 nm, der monokline Anteil 85,5%. Die Dichte betrug 5,67 g/cm³. Nach der Mischungsregel sind das 97,3% der theoretischen Dichte.

### Beispiel 10

Es wurde ein Polymercompound gemäß Beispiel 2 hergestellt. Nach dem Entbindern der organischen Bestandteile und zweistündigem Sintern an Luft bei 970°C wurde ein keramischer Körper erhalten. Er wies eine Dichte von über 95% der theoretischen Dichte auf (5,67 g/cm³). Der monokline Anteil betrug 20,5 %. Die chemische Analyse ergab weniger als 0,8 Mol-% Fremdelemente, ausgenommen Hafnium.

## Patentansprüche

1. Polymercompound umfassend ein keramisches Pulver und ein Polymer, **dadurch gekennzeichnet, dass** das keramische Pulver eine spezifische Oberfläche von mehr als 1,8·10⁸ m²/m³ aufweist und mehr als 5 Vol.-% des Polymercompounds beträgt, das Polymer scherkraftbeständig ist und die Porengrößen im Polymercompound 3-15nm betragen.

2. Polymercompound nach Anspruch 1, **dadurch gekennzeichnet, dass** das keramische Pulver mehr als 40 Vol.-% des Polymercompounds beträgt.

3. Polymercompound nach Anspruch 2, **dadurch gekennzeichnet, dass** das keramische Pulver weniger als 50 Vol.-% des Polymercompounds beträgt.

4. Polymercompound nach einem der vorangehenden Ansprüche, **dadurch gekennzeichnet, dass** der Polymercompound zusätzlich eine oder mehrere gesättigte oder ungesättigte C₂-C₁₈-Carbonsäuren und/oder ein oder mehrere gesättigte oder ungesättigte C₂-C₁₈-alkyl-dimethylsubstituierte Chlorsilane und/oder ein oder mehrere gesättigte oder ungesättigte C₂-C₁₈-Alkylamine aufweist.

5. Polymercompound nach einem der vorangehenden Ansprüche, **dadurch gekennzeichnet, dass** das keramische Pulver eine spezifische Oberfläche von mehr als 2,5·10⁸ m²/m³ aufweist.

6. Polymercompound nach einem der vorhergehenden Ansprüche, **dadurch gekennzeichnet, dass** das Polymer ein Polyolefin, einen Polyester oder ein Polyamid als Thermoplast umfaßt.

7. Polymercompound nach einem der vorhergehenden Ansprüche, **dadurch gekennzeichnet, dass** das Polyolefin HD-Polyethylen, LD-Polyethylen, ein Copolymeres aus Polyethylen mit Vinylacetat oder Butylacrylat, Propylen sowie ein mit Acrylsäure oder Maleinsäureanhydrid gepfropftes Polypropylen ist, der Polyester vom Typ Polyethylenterephthalat, Polybutylenterephthalat, Polycarbonat oder Polylacton, das Polyamid vom Typ Polyamid 6, Polyamid 12 oder Polyamid 66 ist.

8. Polymercompound nach einem der vorhergehenden Ansprüche, **dadurch gekennzeichnet, dass** das keramische Pulver Metalloxide, Carbide, Nitride oder deren Mischungen umfasst.

9. Polymercompound nach Anspruch 8, **dadurch gekennzeichnet, dass** das keramische Pulver ZrO₂, Al₂O₃, SiO₂, TiO₂, Y₂O₃ oder MgO oder deren Mischungen umfaßt.

10. Polymercompound nach Anspruch 9, **dadurch gekennzeichnet, dass** SiO₂ ein amorphes SiO₂ ist.

11. Verfahren zur Herstellung eines Polymercompounds nach Anspruch 1 unter Verwendung eines keramischen Pulvers und eines Thermoplasten, **dadurch gekennzeichnet, dass** als keramisches Pulver eines mit einer spezifischen Oberfläche von mehr als 1,8·10⁸ m²/m³ und als Thermoplast ein scherkraftbeständiges Polymer in einem Kneter mit einer derart hohen Scherkraft geknetet werden, daß die Porengrößen im Polymercompound bei einer Füllung des Polymers mit dem keramischen Pulver von mindestens 5 Vol.-% 3-15 nm betragen.

12. Verfahren zur Herstellung eines Polymercompounds nach einem der Ansprüche 4 bis 10 unter Verwendung eines keramischen Pulvers und eines Thermoplasten, **dadurch gekennzeichnet, dass** das Kneten zusammen mit einer oder mehreren gesättigten oder ungesättigten C₂-C₁₈-Carbonsäuren und/oder einem oder mehreren gesättigten oder ungesättigten C₂-C₁₈-alkyl-dimethylsubstituierten Chlorsilanen und/oder eines oder mehreren gesättigten oder ungesättigten C₂-C₁₈-Alkylaminen durchgeführt wird.

13. Verwendung eines Polymercompounds nach einem der Ansprüche 1 bis 10 als Ausgangsstoff für die keramische Formgebung durch Spritzguß, Extrusion, Warm- und Kaltpressen oder Walzen.

14. Verwendung nach Anspruch 13, **dadurch gekennzeichnet, dass** als Formkörper bei der Extrusion Stränge oder Hohlstränge beliebigen Querschnitts sowie Folien und im Spritzgußverfahren komplexe dreidimensionale Körper erzeugt werden.

15. Verwendung eines Polymercompounds nach einem der Ansprüche 1 bis 10 als partikelverstärkter Kunststoff.

16. Verwendung eines Polymercompounds nach einem der Ansprüche 1 bis 10 als Masterbatch zur Herstellung gefüllter Kunststoffe.

17. Verwendung eines Polymercompounds nach einem der Ansprüche 1 bis 10 als Leiterplattenmaterial.

18. Verwendung eines Polymercompounds nach einem der Ansprüche 1 bis 10 als Vergussmasse für elektrische oder elektronische Komponenten.

19. Verfahren zur Herstellung eines keramischen Sinterkörpers, **dadurch gekennzeichnet, dass** ein Polymercompound gemäß einem der Ansprüche 2 bis 10 nach seiner Formgebung entbindert und gesintert wird.

20. Sinterkörper, hergestellt aus einem Polymercompound nach einem der Ansprüche 1 bis 9, aus ZrO₂ mit einem tetragonalen Phasenanteil und mit einer Porosität von weniger als 5 %, **dadurch gekennzeichnet, dass** er weniger als 0,8 Mol-% Fremdatome, ausgenommen Hafnium, und einen monoklinen Phasenanteil von weniger als 90% aufweist.

## Claims

1. Polymer compound comprising a ceramic powder and a polymer, **characterized in that** the ceramic powder has a specific surface area of more than 1.8·10⁸ m²/m³ and is greater than 5 vol.% of the polymer compound, the polymer is shear resistant, and the pore sizes in the polymer compound are 3-15 nm.

2. Polymer compound according to Claim 1, **characterized in that** the ceramic powder is greater than 40 vol.% of the polymer compound.

3. Polymer compound according to Claim 2, **characterized in that** the ceramic powder is less than 50 vol.% of the polymer compound.

4. Polymer compound according to any preceding claim, **characterized in that** the polymer compound further comprises one or more saturated or unsaturated C₂-C₁₈ carboxylic acids and/or one or more saturated or unsaturated C₂-C₁₈ alkyl dimethyl substituted chlorosilanes and/or one or more saturated or unsaturated C₂-C₁₈ alkylamines.

5. Polymer compound according to any preceding claim, **characterized in that** the ceramic powder has a specific surface area of more than 2.5·10⁸ m²/m³.

6. Polymer compound according to any preceding claim, **characterized in that** the polymer comprises a polyolefin, a polyester or a polyamide as thermoplastic.

7. Polymer compound according to any preceding claim, **characterized in that** the polyolefin is HD polyethylene, LD polyethylene, a copolymer of polyethylene with vinyl acetate or butyl acrylate, propylene and also an acrylic acid or maleic anhydride grafted polypropylene, the polyester is of the polyethylene terephthalate, polybutylene terephthalate, polycarbonate or polylactone type, and the polyamide is of the polyamide 6, polyamide 12 or polyamide 66 type.

8. Polymer compound according to any preceding claim, **characterized in that** the ceramic powder comprises metal oxides, carbides, nitrides or their mixtures.

9. Polymer compound according to Claim 8, **characterized in that** the ceramic powder comprises ZrO₂, Al₂O₃, SiO₂, TiO₂, Y₂O₃ or MgO or their mixtures.

10. Polymer compound according to Claim 9, **characterized in that** SiO₂ is an amorphous SiO₂.

11. Method of manufacturing a polymer compound according to Claim 1 by using a ceramic powder and a thermoplastic, **characterized in that** a ceramic powder having a specific surface area of more than 1.8·10⁸ m²/m³ and a shear-resistant thermoplastic polymer are kneaded in a kneader with such a high shearing force that the pore sizes in the polymer compound are 3-15 nm when the polymer is filled with at least 5 vol.% of ceramic powder.

12. Method of manufacturing a polymer compound according to any one of Claims 4 to 10 by using a ceramic powder and a thermoplastic, **characterized in that** the kneading is effected together with one or more saturated or unsaturated C₂-C₁₈ carboxylic acids and/or one or more saturated or unsaturated C₂-C₁₈ alkyl dimethyl substituted chlorosilanes and/or one or more saturated or unsaturated C₂-C₁₈ alkylamines.

13. Use of a polymer compound according to any one of Claims 1 to 10 as starting material for ceramic shaping by injection moulding, extrusion, warm or cold pressing, or rolling.

14. Use according to Claim 13, **characterized in that** shaped articles produced comprise solid or hollow strands of any desired cross-section and also sheets in extrusion and complex three-dimensional bodies in the injection moulding process.

15. Use of a polymer compound according to any one of Claims 1 to 10 as particle-reinforced plastic.

16. Use of a polymer compound according to any one of Claims 1 to 10 as masterbatch for manufacturing filled plastics.

17. Use of a polymer compound according to any one of Claims 1 to 10 as circuit board material.

18. Use of a polymer compound according to any one of Claims 1 to 10 as potting compound for electrical or electronic components.

19. Method of manufacturing a ceramic sintered article, **characterized in that** a polymer compound according to any one of Claims 2 to 10 is shaped and subsequently debindered and sintered.

20. Sintered article obtained from the polymer compound according to any one of Claims 1 to 9, comprising ZrO₂ having a tetragonal phase component and having a porosity of less than 5%, **characterized in that** it has less than 0.8 mol% of foreign atoms, except hafnium, and a monoclinic phase component of less than 90%.

## Revendications

1. Composé polymère comprenant une poudre céramique et un polymère,
**caractérisé en ce que**
la poudre céramique présente une surface spécifique de plus de 1,8 · 10⁸ m²/m³ et représente plus de 5 % en volume du composé polymère, le polymère est résistant aux forces de cisaillement et les dimensions des pores dans le composé polymère sont comprises entre 3 et 15 nm.

2. Composé polymère selon la revendication 1,
**caractérisé en ce que**
la poudre céramique représente plus de 40 % en volume du composé polymère.

3. Composé polymère selon la revendication 2,
**caractérisé en ce que**
la poudre céramique représente moins de 50 % en volume du composé polymère.

4. Composé polymère selon l'une des revendications précédentes,
**caractérisé en ce que**
le composé polymère présente en supplément un ou plusieurs acides carboniques C₂-C₁₈ saturés ou insaturés et/ou un ou plusieurs chlorosilanes C₂-C₁₈-alkyle-diméthylsubstitués saturés ou insaturés et/ou une ou plusieurs alkylamines C₂-C₁₈ saturées ou insaturées.

5. Composé polymère selon l'une des revendications précédentes,
**caractérisé en ce que**
la poudre céramique présente une surface spécifique de plus de 2,5. · 10⁸ m²/m³.

6. Composé polymère selon l'une des revendications précédentes,
**caractérisé en ce que**
le polymère comprend une polyoléfine, un polyester ou un polyamide en tant que thermoplaste.

7. Composé polymère selon l'une des revendications précédentes,
**caractérisé en ce que**
la polyoléfine est du polyéthylène HD, du polyéthylène LD, un copolymère de polyéthylène avec du vinylacétate ou du butylacrylate, du propylène ainsi qu'un polypropylène greffé avec de l'acide acrylique ou de l'anhydride d'acide maléique, le polyester est du type polyéthylènetéréphtalate, polybutylènetéréphtalate, polycarbonate ou polylactone, le polyamide est du type polyamide 6, polyamide 12 ou polyamide 66.

8. Composé polymère selon l'une des revendications précédentes,
**caractérisé en ce que**
la poudre céramique comprend des oxydes métalliques, des carbures, des nitrures ou leurs mélanges.

9. Composé polymère selon la revendication 8,
**caractérisé en ce que**
la poudre céramique comprend ZrO₂, Al₂O₃, SiO₂, TiO₂, Y₂O₃ ou MgO ou leurs mélanges.

10. Composé polymère selon la revendication 9,
**caractérisé en ce que**
SiO₂ est un SiO₂ amorphe.

11. Procédé de fabrication d'un composé polymère selon la revendication 1 en utilisant une poudre céramique et un thermoplaste,
**caractérisé en ce qu'**
en tant que poudre céramique on malaxe dans un malaxeur, une poudre ayant une surface spécifique de plus de 1,8 · 10⁸ m²/m³ et, en tant que thermoplaste, un polymère résistant aux forces de cisaillement avec une force de cisaillement telle que les dimensions des pores dans le composé polymère, lors d'un remplissage du polymère avec la poudre céramique à au moins 5 % en volume, sont comprises entre 3 et 15 nm.

12. Procédé de fabrication d'un composé polymère selon l'une des revendications 4 à 10 en utilisant une poudre céramique et un thermoplaste,
**caractérisé en ce que**
le malaxage est réalisé conjointement avec un ou plusieurs acides carboniques C₂-C₁₈ saturés ou insaturés et/ou un ou plusieurs chlorosilanes C₂-C₁₈-alkyle-diméthylsubstitués saturés ou insaturés et/ou une ou plusieurs alkylamines C₂-C₁₈ saturées ou insaturées.

13. Utilisation d'un composé polymère selon l'une des revendications 1 à 10 en tant que substance initiale pour le modelage céramique par moulage par injection, extrusion, pressage à chaud et à froid ou laminage.

14. Utilisation selon la revendication 13,
**caractérisée en ce qu'**
lors de l'extrusion, on produit en tant que corps moulés, des cordons ou des cordons creux de section transversale quelconque ainsi que des feuilles, et dans le procédé de moulage par injection, des corps tridimensionnels complexes.

15. Utilisation d'un composé polymère selon l'une des revendications 1 à 10 en tant que matière synthétique renforcée en particules.

16. Utilisation d'un composé polymère selon l'une des revendications 1 à 10 en tant que mélange-maître pour la fabrication de matières synthétiques remplies.

17. Utilisation d'un composé polymère selon l'une des revendications 1 à 10 en tant que matériau de carte de circuit imprimé.

18. Utilisation d'un composé polymère selon l'une des revendications 1 à 10 en tant que masse de coulage pour des composants électriques ou électroniques.

19. Procédé de fabrication d'un corps fritté en céramique,
**caractérisé en ce qu'**
un composé polymère selon l'une des revendications 2 à 10, après son moulage, est délivré et fritté.

20. Corps fritté, fabriqué à partir d'un composé polymère en ZrO₂ selon l'une des revendications 1 à 9, avec une part de phase tétragonale et avec une porosité de moins de 5 %,
**caractérisé en ce qu'**
il présente moins de 0,8 % en mole d'atomes étrangers, excepté de hafnium, et une part de phase monoclinale de moins de 90 %.
